# EUROPEAN PATENT APPLICATION

(11) **EP 2 315 039 A1**
(43) Date of publication of application: **27.04.2011**
(21) Application number: 09773525.2
(22) Date of filing: 02.07.2009
(51) Int. Cl.: G01P 15/125, H01L 29/84

(54) **CAPACITANCE DETECTION TYPE MOVABLE SENSOR**

(30) Priority: 04.07.2008 JP 2008176155; 30.03.2009 JP 2009081944
(71) Applicant: Alps Electric Co., Ltd., Tokyo 145-8501 (JP)
(72) Inventor: YAZAWA, Hisayuki, Tokyo 145-8501 (JP); SATO, Kiyoshi, Tokyo 145-8501 (JP); TAKAHASHI, Toru, Tokyo 145-8501 (JP); OHKAWA, Hisanobu, Tokyo 145-8501 (JP)
(74) Representative: Wohlfrom, Karl-Heinz
(86) International application number: PCT/JP2009/062082
(87) International publication number: WO 2010/001947

(57) **Abstract**

[Object] To provide a movable sensor with thin and compact structure which is capable of detecting displacement of a movable portion with high accuracy.

[Solution] A first movable portion 2 and a second movable portion 4 are connected with a connection link portion 10a and a support link portion 20a. As the first movable portion 2 approaches a fixed portion 50, the second movable portion 4 is so structured to move away from the fixed portion 50. The fixed portion 50 is provided with a first fixed electrode 51 and a second fixed electrode 52. A first movable electrode opposite the first fixed electrode is provided on an upper surface 2a of the first movable portion 2, and a second movable electrode opposite the second fixed electrode 52 is provided on an upper surface 4a of the second movable portion 4. As the first movable portion 2 and the second movable portion 4 move in opposite directions, the displacement state of the first movable portion 2 may be detected using the difference of the change in the electrostatic capacity between the first fixed electrode 51 and the first movable electrode, and the second fixed electrode 52 and the second movable electrode.

## Description

### Technical Field

The present invention relates to a movable sensor of electrostatic capacity detection type, which detects displacement of a movable portion formed by cutting a silicon substrate based on change in electrostatic capacity between electrodes so as to ensure measurement of physical amount such as externally acing acceleration.

### Background Art

The sensor as disclosed in the following patent literatures 1 to 3 has a movable portion formed by etching the silicon substrate for operating in a planar direction or in a direction orthogonal to the plane. The sensor detects each electrostatic capacity of a movable electrode provided on the movable portion and a fixed electrode opposite the movable electrode for measuring displacement of the movable portion.

As the movable portion of the aforementioned sensor is considerably miniaturized, the electrode has to be structured so that the displacement of the movable portion is accurately obtained based on the change in the electrostatic capacity between electrodes. The generally employed sensor disclosed in the following patent literatures has the movable portion and the fixed portion, both of which are finely pectinated, and in mesh with each other. This makes it possible to enlarge the area of the region where the movable electrode provided on the movable portion faces the fixed electrode provided on the fixed portion as wide as possible. The structure which brings the pectinated movable portion and fixed portion into an engagement state is complicated, thus increasing processing cost.

Meanwhile, the movable electrodes are provided both on the upper surface and a back surface of the movable portion, and fixed electrodes which face the movable electrodes attached to the upper surface and the back surface are provided. A difference between the change in the electrostatic capacity between one of the movable electrode and the fixed electrode, and the change in the electrostatic capacity between the other of the movable electrode and the fixed electrode is obtained. The aforementioned method obtains the difference of the change in the electrostatic capacity between the movable electrodes which are provided on both surfaces of the movable electrode to allow improvement of detection sensitivity. Additionally, the difference between the detected output of the electrostatic capacity which changes at the positive side and the detected output of the electrostatic capacity which changes at the negative side is obtained to allow cancellation of fluctuation and noise owing to environmental change such as temperature change, thus providing quality detection output.

The aforementioned structure requires the movable electrodes to be provided on the upper and back surfaces of the movable portion, which complicates the structure of the movable portion. The fixed electrode opposite the movable electrode on the upper surface via an appropriate gap, and the fixed electrode opposite the movable electrode on the back surface via an appropriate gap are required as well. This may complicate the structure of the fixed portion, and require setting of each gap between the fixed electrode and the upper/back surface of the movable portion, resulting in complicated assembling work.

### Citation List

### Patent Literature

PTL 1: Japanese Unexamined Patent Application Publication No. 2003-14778
PTL 2: Japanese Unexamined Patent Application Publication No. 2006-266873
PTL 3: Japanese Unexamined Patent Application Publication No. 2007-298385

### Summary of Invention

### Technical Problem

The present invention has been made to solve the aforementioned conventional problem, and it is an object of the present invention to provide a movable sensor of electrostatic capacity detection type, capable of obtaining a difference of detection outputs of the electrostatic capacity, which change in opposite directions using plural movable electrodes provided on a surface of one side of the movable portion. The sensor with simple structure is further capable of obtaining the output with good sensitivity while canceling noise.

### Solution to Problem

The present invention provides a movable sensor which has electrodes oppositely provided on a movable portion and a fixed portion for detecting a change in an electrostatic capacity between the electrodes when the movable portion moves close to or away from the fixed portion. A first movable portion, a second movable portion, and link portions which are rotatably connected to both of the movable portions are provided. The link portion is operable so that one of the first movable portion and the second movable portion moves close to the fixed portion and the other moves away from the fixed portion when the link portion rotates with respect to a fulcrum which is set between a connection portion connected to the first movable portion and a connection portion connected to the second movable portion. A first movable electrode is provided on the first movable portion, and a second movable electrode is provided on the second movable portion on a surface in a same direction as each of the movable portions, and the fixed portion includes a first fixed electrode opposite the first movable electrode, and a second fixed electrode opposite the second movable electrode.

The movable sensor according to the present invention is structured so that the first movable portion and the second movable portion are connected to move in opposite directions. Change in the electrostatic capacity between the first movable portion and the fixed portion, and change in the electrostatic capacity between the second movable portion and the fixed portion are output at opposite phases. The difference of the change in the electrostatic capacity allows detection of the moving state of the movable portion with high sensitivity while canceling noise owing to temperature change. The movable electrodes are provided on the surfaces of the first and the second movable portions at the same sides. This makes it possible to easily form the electrode.

In the present invention, the movable electrodes may be formed on both upper and back surfaces of the first movable portion, and the movable electrodes may be formed on both upper and back surfaces of the second movable portion so that the fixed electrodes opposite the respective movable electrodes on the upper and the back surfaces are provided on the fixed portion. In this case, the movable electrodes are provided on the upper and back surfaces of the movable portion, and the fixed electrodes are provided on the fixed portion opposite the upper and back surfaces of the movable portion. This may complicate the structure to some extent. In such a case, each change in the electrostatic capacity at the same phase, which is detected by the electrode on all the surfaces is added, and the difference of the changes at opposite phases is further obtained to provide the detection output with high sensitivity while cancelling noise.

The present invention is provided with a detection circuit which detects a difference between the change in the electrostatic capacity between the first movable electrode and the first fixed electrode, and the change in the electrostatic capacity between the second movable electrode and the second fixed electrode.

The detection circuit makes it possible to provide quality detection outputs while cancelling fluctuation and noise owing to the temperature property.

For example, the present invention may be structured such that one of the first movable portion and the second movable portion has mass larger than that of the other, the movable portion in larger mass moves in response to an externally applied acceleration, and the movable portion in smaller mass moves in an opposite direction of the movable portion in larger mass.

As described above, the acceleration sensor may be structured so that one of the movable portions, which is larger in mass undergoes reaction to acceleration. In the case where one of the movable portions is larger in mass than the other movable portion, when an attitude of the movable sensor is changed with respect to the gravity direction, the movable portion larger in mass moves toward the gravity direction. This makes it possible to detect the resultant displacement. In this way, the movable sensor may be used for measuring attitude with respect to the gravity direction.

In the present invention, the first movable portion has a same thickness as that of the second movable portion. When each upper surface and a back surface of the first and the second movable portions is in the same plane, the link portion and a support portion for rotatably supporting the link portion are located in a thickness range defined by the upper surface and the back surface.

In the present invention, for example, the first movable portion, the second movable portion, the link portion and the support portion are cut from a same plate material.

In the present invention, a connection portion between the first movable portion and the link portion, a connection portion between the second movable portion and the link portion, and a connection portion between the link portion and the support portion at the fulcrum have respective members rotatably connected via torsion bars, each of which is formed of a part of the plate material.

Use of the aforementioned torsion bar allows the respective members to be rotatably connected with the connection portions, respectively. When the external force is not exerted, elastic force of the torsion bar allows restoration of the stationary attitude.

As described above, the first and the second movable portions, the link portion, and the support portion are formed by cutting the single plate material such as the silicon substrate so as to realize the movable sensor with considerably small and thin structure.

The present invention may be structured such that an electrically conductive material is used for forming the first movable portion and the second movable portion, the first movable portion generally functions as the first movable electrode, and the second movable portion generally functions as the second movable electrode.

According to the present invention, the link portion includes a right connection link portion and a left connection link portion extending in a front-to-rear (X) direction which are apart from each other in a left-to-right (Y) direction, the right connection link portion is rotatably supported with a first right support portion via a right fulcrum, and the left connection link portion is rotatably supported with the first left support portion via a left fulcrum. Any one of a connection portion between the right connection link portion and the first movable portion and a connection portion between the left connection link portion and the first movable portion is located at a front position (X1), and the other is located at a rear position (X2). A connection portion between the right connection link portion and the second movable portion is located opposite a connection portion between the right connection link portion and the first movable portion in the front-to-rear direction with respect to the right fulcrum, and a connection portion between the left connection link portion and the second movable portion is located opposite a connection portion between the left connection link portion and the first movable portion in the front-to-rear direction with respect to the left fulcrum. The first right support portion and the first left support portion are fixed to the fixed portion.

As described above, the right and left connection link portions are provided to allow the first and the second movable portions to move in vertically opposite directions while holding substantially horizontal attitudes.

In the present invention, preferably, the right outer support link portion is rotatably connected to the first right support portion and the first movable portion, and a connection portion between the right outer support link portion and the first movable portion is located opposite a connection portion between the right connection link portion and the first movable portion in the front-to-rear direction. The left outer support link portion is rotatably connected to the first left support portion and the first movable portion, and a connection portion between the left outer support link portion and the first movable portion is located opposite a connection portion between the left connection link portion and the first movable portion in the front-to-rear direction.

In the present invention, preferably, a right inner support link portion is rotatably connected to the second right support portion and the second movable portion, and a connection portion between the right inner support link portion and the second movable portion is located opposite a connection portion between the right connection link portion and the second movable portion in the front-to-rear direction. The left inner support link portion is rotatably connected to the second left support portion and the second movable portion, and a connection portion between the left inner support link portion and the second movable portion is located opposite a connection portion between the left connection link portion and the second movable portion in the front-to-rear direction.

As described above, besides the right connection link portion and the left connection link portion, the right outer support link portion and the left outer support link portion, and the right inner support link portion and left inner support link portion are provided to allow the first movable portion and the second movable portion to move up and down while holding the stable horizontal attitudes.

Preferably, the first right support portion and the first left support portion are aligned on the same line which extends in the left-to-right (Y) direction.

Further preferably, the first right support portion and the first left support portion, and the second right support portion and the second left support portion are aligned on the same line which extends in the left-to-right (Y) direction.

As described above, the first right support portion and the first left support portion are aligned on the same line in the left-to-right direction, and the first right support portion and the first left support portion, the second right support portion and the second left support portion are aligned on the same line in the left-to-right direction so that the first movable portion and the second movable portion are allowed to be kept at neutral position even if warrpage occurs in the fixed portion owing to heat and external force.

The present invention may be formed such that a right outer support link portion is rotatably connected to the right connection link portion via an inter-link connection portion, and a left outer support link portion is rotatably connected to the left connection link portion via an inter-link connection portion. A connection portion between the right outer support link portion and the first movable portion is located opposite a connection portion between the right connection link portion and the first movable portion in the front-to-rear direction with respect to the inter-link connection portion. A connection portion between the left outer support link portion and the first movable portion is located opposite a connection portion between the left connection link portion and the first movable portion in the front-to-rear direction with respect to the inter-link connection portion. A connection portion between the right outer support link portion and the first movable portion is located opposite a connection portion between the left outer support link portion and the first movable portion in the front-to-rear direction.

Preferably, a right inner support link portion is rotatably connected to the right connection link portion via an inner inter-link connection portion, and a left inner support link portion is rotatably connected to the left connection link portion via an inner inter-link connection portion. A connection portion between the right inner support link portion and the second movable portion is located opposite a connection portion between the right connection link portion and the second movable portion in the front-to-rear direction with respect to the inner inter-link connection portion. A connection portion between the left inner support link portion and the second movable portion is located opposite a connection portion between the left connection link portion and the second movable portion in the front-to-rear direction with respect to the inner inter-link connection portion. A connection portion between the right inner support link portion and the second movable portion is located opposite a connection portion between the left inner support link portion and the second movable portion in the front-to-rear direction.

As described above, the right inner support link portion and the right connection link portion are rotatably connected, and the left inner support link portion and the left connection link portion are rotatably connected so as to eliminate the need of providing the second right support portion and the second left support portion. As the number of the support portions is reduced, difference in the height or slope among the support portions may be prevented even if warrpage occurs in the fixed portion owing to heat and external force. This makes it possible to stabilize the operation attitudes of the first and the second movable portions.

In the aforementioned case, preferably, the inter-link connection portion and the inner inter-link connection portion are aligned on the same line which extends in the left-to-right (Y) direction.

The inter-link connection portion and the inner inter-link connection portion are aligned on the same line to allow the link portions to be operated in well-balanced state.

### Advantageous Effects of Invention

The movable sensor according to the present invention has the first movable portion and the second movable portion which move in opposite directions. This makes it possible to obtain the change in the electrostatic capacity at different phases from the movable electrodes provided on surfaces of the first movable portion and the second movable portion in the same direction. The obtained difference may provide the detection output with high sensitivity while canceling the fluctuation such as noise owing to the temperature change.

The movable sensor according to the present invention may be formed into a considerably small and thin structure. Brief Description of Drawings
[Fig. 1] Fig. 1 is a perspective view illustrating a state where a movable sensor according to a first embodiment of the present invention is static.
[Fig. 2] Fig. 2 is a perspective view illustrating a state where the movable sensor according to the first embodiment of the present invention is operational.
[Fig. 3] Fig. 3 is a side view illustrating a state where the movable sensor according to the first embodiment of the present invention is operational.
[Fig. 4] Fig. 4 is an enlarged perspective view of a connection portion shown in Fig. 1.
[Fig. 5] Fig. 5 is an enlarged perspective view showing a fulcrum connection portion and an inter-link connection portion shown in Fig. 1.
[Fig. 6] Fig. 6 is a perspective view illustrating a state where a movable sensor according to a second embodiment of the present invention is static.
[Fig. 7] Fig. 7 is a perspective view illustrating a state where the movable sensor according to the second embodiment of the present invention is operational.
[Fig. 8] Fig. 8 is a circuit diagram of a detection circuit.
[Fig. 9] Fig. 9 is a plan view illustrating a state where a movable sensor according to a third embodiment of the present invention is static.
[Fig. 10] Fig. 10 is a perspective view illustrating a state where the movable sensor according to the third embodiment of the present invention is operational.
[Fig. 11} Fig. 11 is a plan view illustrating a state where a movable sensor according to a fourth embodiment of the present invention is static.
[Fig. 12] Fig. 12 is a perspective view illustrating a state where the movable sensor according to the fourth embodiment of the present invention is operational.

### Best Mode for Carrying Out the Invention

In the drawings, the respective directions with respect to the movable sensor will be defined. That is, a direction Y denotes a left-to-right direction, Y1 denotes a right direction, Y2 denotes a left direction, X denotes a front-to-rear direction, X1 denotes a front direction, and X2 denotes a rear direction. The direction orthogonal both to directions Y and X denotes up-and-down direction.

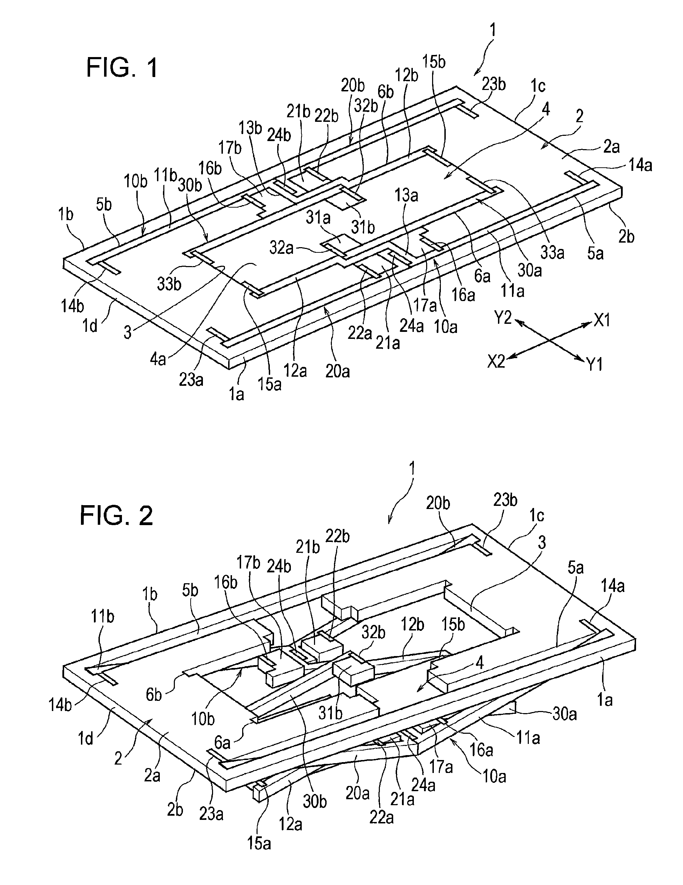

A movable sensor 1 shown in Fig. 1 is formed of a silicon substrate as a flat rectangular plate. That is, a flat resist layer corresponding to each shape of the respective members is formed on the silicon substrate, and a part of the silicon substrate, on which the resist layer is not formed is cut in an etching process such as deep RIE (Deep Reactive Ion Etching) for separating the respective members. Each of the respective members which constitute the movable sensor 1 is formed in the range of thickness defined by the upper surface and back surface of the silicon substrate. Referring to Fig. 1, when the movable sensor is static, upper surfaces and back surfaces of a first movable portion and a second movable portion are in the same plane, respectively. The rest of the members do not protrude from the upper and the back surfaces.

The movable sensor 1 is miniaturized, and has each of longer sides 1a, 1b of a rectangular shape set to 1 mm or shorter, shorter sides 1c, 1d set to 0.8 mm or shorter, and a thickness set to 0.1 mm or smaller.

Referring to Figs. 1 and 2, the movable sensor 1 has the first movable portion 2 as a rectangular outer frame defined by long sides 1a, 1b and short sides 1c, 1d. The direction along which the long sides 1a, 1b extend is defined as the front-to-rear direction, and the direction along which the short sides 1c, 1d extend is defined as the left-to-right direction. A rectangular center hole 3 is formed in the center of the first movable portion 2 while vertically penetrating therethrough. A second movable portion 4 is provided in the center hole 3. The second movable portion 4 has a substantially rectangular shape, and functions independently from the first movable portion 2.

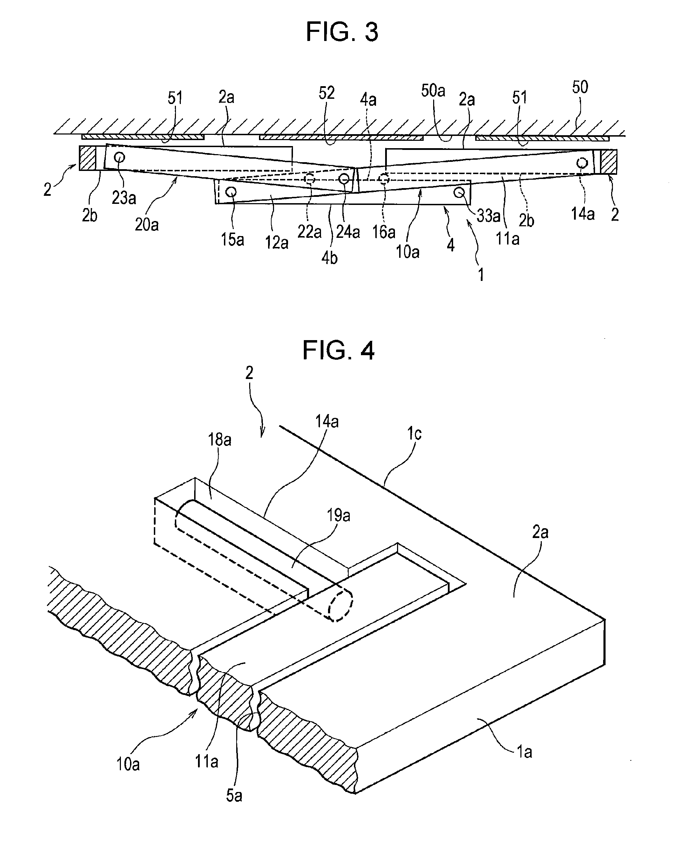

Referring to a neutral state (static state) shown in Fig. 1, an upper surface 2a of the first movable portion 2 is in the same plane with an upper surface 4a of the movable portion 4. A back surface 2b of the first movable portion 2 is in the same plane with a back surface 4b (see Fig. 3) of the second movable portion 4. An area of the upper surface 2a of the first movable portion 2 is larger than that of the upper surface 4a of the second movable portion 4. Mass of the first movable portion 2 is larger than that of the second movable portion 4. For example, mass of the first movable portion 2 is twice larger than that of the second movable portion 4.

A long hole 5a extending along the long side 1a is formed at the inner side of the right long side 1a (Y1 side) of the rectangular structure, and a long hole 5b extending along the long side 1b is formed at the inner side of the left long side 1b (Y2 side) of the rectangular structure. A thin and long gap 6a between the long side of the center hole 3 of the second movable portion and the long side of the second movable portion 4 is formed at the inner side of the right long hole 5a parallel thereto. A thin and long gap 6b between the long side of the center hole 3 and the long side of the second movable portion 4 is formed at the inner side of the left long hole 5b parallel thereto.

Referring to Fig. 1, a right connection link portion 10a is provided at the inner side of the right long side 1a. The right connection link portion 10a has a planar crank shape, and is integrally formed with a first connection arm 11a extending forward (X1 direction), and a second connection arm 12a extending rearward (X2 direction) and an intermediate connection portion 13a. The first connection arm 11a is cut from the silicon substrate in the long hole 5a which extends at the inner side of the long side 1a. The second connection arm 12a is cut from the silicon substrate in the gap 6a which extends at the inner side of the long hole 5a. The first connection arm 11a and the second connection arm 12a are connected integrally with the intermediate connection portion 13a which is orthogonal to those arms.

A front (X1 direction) end portion of the first connection arm 11a of the right connection link portion 10a and the first movable portion 2 are rotatably connected with a connection portion 14a. A rear (X2 direction) end portion of the second connection arm 12a of the right connection link portion 10a and the second movable portion 4 are rotatably connected with a connection portion 15a. A first right support portion 17a is independently cut at a portion adjacent to the first connection arm 11a and the intermediate connection portion 13a of the right connection link portion 10a. The first connection arm 11a of the right connection link portion 10a and the first right support portion 17a are rotatably connected at a fulcrum connection portion 16a.

A left connection link portion 10b is provided at the inner side of the left long side 1b. The left connection link portion 10b is point symmetrical with respect to the right connection link portion 10a, which is integrally formed with a first connection arm 11b extending rearward (X2 direction) and a second connection arm 12b extending forward (X1 direction) and an intermediate connection portion 13b. The first connection arm 11b is provided in the long hole 5b which extends at the inner side of the long side 1b. The second connection arm 12b is provided in the gap 6b which extends at the inner side of the long hole 5b. The first connection arm 11b and the second connection arm 12b are integrally connected with the intermediate connection portion 13b which is orthogonal to those members.

Referring to Fig. 1, a rear end portion (X2) of the first connection arm 11b of the left connection link portion 10b and the first movable portion 2 are rotatably connected with a connection portion 14b. A front (X1 direction) end portion of the second connection arm 12b of the left connection link portion 10b and the second movable portion 4 are rotatably connected with a connection portion 15b. A first left support portion 17b is independently cut at a portion adjacent to the first connection arm 11b and the intermediate connection portion 13b of the left connection link portion 10b. The first connection arm 11b of the left connection link portion 10b and the first left support portion 17b are rotatably connected at a fulcrum connection portion 16b.

Referring to Fig. 4, a groove 18a is formed in the first movable portion 2 at the connection portion 14a. A torsion bar 19a is provided inside the groove 18a for joining the first connection arm 11a of the right connection link portion 10a and the first movable portion 2. The torsion bar 19a is formed of silicon likewise the first movable portion 2 and the right connection link portion 10a. Specifically, the torsion bar 19a is formed by etching the rectangular silicon substrate, and processing the silicon into a cylindrical or a square columnar shape while leaving a part of the silicon substrate to connect the first movable portion 2 and the first connection arm 11a upon separation of the first movable portion 2 and the right connection link portion 10a.

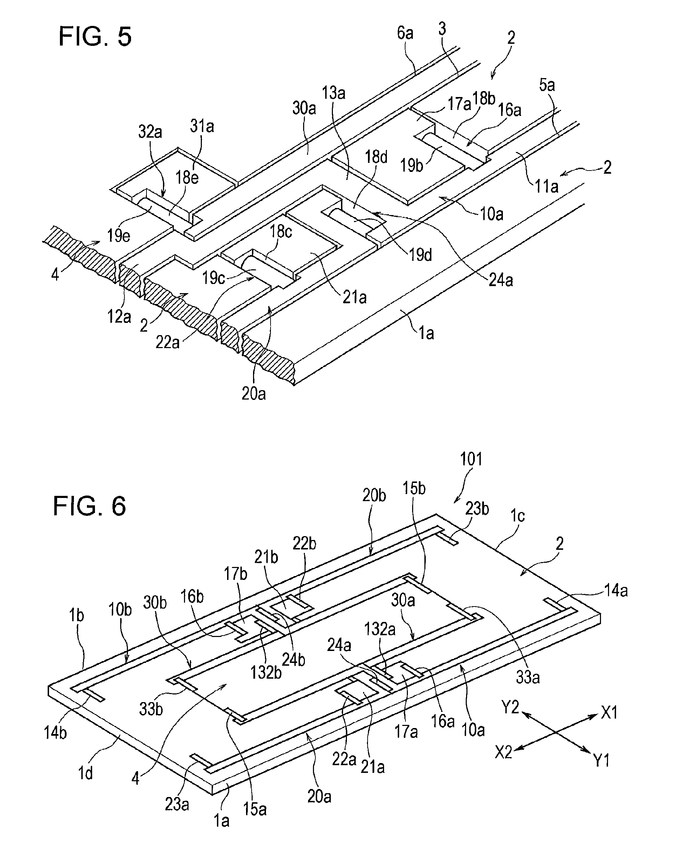

Referring to Fig. 5, the fulcrum connection portion 16a has a groove 18b between the first movable portion 2 and the first right support portion 17a. The right connection link portion 10a and the first right support portion 17a are connected with a torsion bar 19b formed of the silicon in the groove 18b.

At the connection portion 14a shown in Fig. 4, the torsion bar 19a torsionally deforms to relatively rotate the first connection arm 11a and the first movable portion 2. Likewise, at the fulcrum connection portion 16a shown in Fig. 5, the torsion bar 19b torsionally deforms to relatively rotate the right connection link portion 10a and the first right support portion 17a. As the silicon for forming the torsion bars 19a and 19b is an elastic material, elastic restoring forces of the torsion bars 19a and 19b serve to restore so that the upper surface 2a of the first movable portion 2 is in the same plane with the upper surface of the first connection arm 11a when external force does not act on the first movable portion 2.

The connection portion 15a for connecting the second connection arm 12a of the right connection link portion 10a and the second movable portion 4 is also integrally formed with the torsion bar in the same way as described above. Further, connection portions 14b, 15b and the fulcrum connection portion 16b for connecting the left connection link portion 10b, the first movable portion 2 and the second movable portion 4 are also integrally formed with the torsion bars, respectively to form rotary portions each with elastic restoring force.

Inside the long hole 5a formed at the inner side of the right long side 1a, a right outer support link portion 20a is cut and formed at a portion where the first connection arm 11a of the right connection link portion 10a does not exist. A second right support portion 21a is cut and formed between the right outer support link portion 20a and the second connection arm 12a of the right connection link portion 10a. A front proximal portion (X1 direction) of the right outer support link portion 20a and the second right support portion 21a are rotatably connected with a fulcrum connection portion 22a.

Referring to Fig. 5, a groove 18c is formed between the second right support portion 21a and the first movable portion 2 at the fulcrum connection portion 22a. A torsion bar 19c for connecting the right outer support link portion 20a and the second right support portion 21a is integrally formed of silicon inside the groove 18c. At the fulcrum connection portion 22a, a rotary support portion is formed for exerting the elastic restoring force under the elastic force of the torsion bar 19c. Referring to Fig. 1, the rear end portion (X2 direction) of the right outer support link portion 20a and the first movable portion 2 are connected with a connection portion 23a. The right outer support link portion 20a and the second movable portion 4 are connected with the torsion bar at the connection portion 23a.

Referring to Figs. 1 and 5, the right outer support link portion 20a and the intermediate connection portion 13a of the right connection link portion 10a are connected with an inter-link connection portion 24a. Referring to Fig. 5, a groove 18d is formed in the inter-link connection portion 24a. A torsion bar 19d for connecting the right outer support link portion 20a and the intermediate connection portion 13a of the right connection link portion 10a is integrally formed in the groove 18d.

The right connection link portion 10a rotates with respect to the torsion bar 19b at the fulcrum connection portion 16a as the fulcrum, and the right outer support link portion 20a rotates with respect to the torsion bar 19c at the fulcrum connection portion 22a as the fulcrum. The torsion bar 19d at the inter-link connection portion 24a is located at the intermediate position between those two torsion bars 19b and 19c. As shown in Fig. 2, when the right connection link portion 10a and the right outer support link portion 20a rotate, the torsion bar 19d at the inter-link connection portion 24a serves to apply the elastic restoring force to restore the respective horizontal attitudes.

Referring to Fig. 1, a left outer support link portion 20b is cut and formed at a portion where the first connection arm 11b of the left connection link portion 10b does not exist in the long hole 5b at the inner side of the left long side 1b. The shape of the left outer support link portion 20b and its support structure are point symmetrical with respect to the right outer support link portion 20a. A rear proximal portion (X2 direction) of the left outer support link portion 20b and a second left support portion 21b are connected with a fulcrum connection portion 22b. A front end portion (X1 direction) of the left outer support link portion 20b and the second movable portion 4 are rotatably connected with a connection portion 23b. The intermediate connection portion 13b of the left connection link portion 10b and the left outer support link portion 20b are connected with an inter-link connection portion 24b. Likewise the structure shown in Fig. 5, the torsion bars are integrally formed with the fulcrum connection portion 22b, the connection portion 23b and the inter-link connection portion 24b, respectively.

Referring to Figs. 1 and 5, a right inner support link portion 30a is cut and formed at a portion where the second connection arm 12a of the right connection link portion 10a does not exist in the right gap 6a. A third right support portion 31a formed by cutting a part of the second movable portion 4 is provided at the inner side of the right inner support link portion 30a. The right inner support link portion 30a and the third right support portion 31a are rotatably connected with a fulcrum connection portion 32a. Referring to Fig. 5, a groove 18e is formed in the fulcrum connection portion 32a. A torsion bar 19e for connecting the right inner support link portion 30a and the third right support portion 31a is integrally formed in the groove 18e.

The torsion bar 19e provided at the fulcrum connection portion 32a is positioned coaxially with the torsion bar 19c which connects the right outer support link portion 20a and the second right support portion 21a.

Referring to Fig. 1, the front end portion (X1 direction) of the right inner support link portion 30a and the second movable portion 4 are rotatably connected with a connection portion 33a. The connection portion 33a is also provided with the torsion bar.

A left inner support link portion 30b is cut and formed at a portion where the second connection arm 12b of the left connection link portion 10b does not exist in the left gap 6b. The shape of the left inner support link portion 30b and its support structure are point symmetrical with respect to the right inner support link portion 30a.

A third left support portion 31b which is formed by cutting a part of the second movable portion 4 is provided at the inner side of the left inner support link portion 30b. The left inner support link portion 30b and the third left support portion 31b are rotatably connected with a fulcrum connection portion 32b. The rear end portion (X2 direction) of the left inner support link portion 30b and the second movable portion 4 are connected with a connection portion 33b. The torsion bars are integrally formed with the fulcrum connection portion 32b and the connection portion 33b, respectively.

Referring to Fig. 3, the movable sensor 1 is provided with a fixed portion 50 that faces the upper surface 2a of the first movable portion 2 and the upper surface 4a of the second movable portion 4. A not shown protruding support member is integrally formed with a lower surface 50a of the fixed portion 50. The support member serves to fix and support the first right support portion 17a, the first left support portion 17b, the second right support portion 21a, the second left support portion 21b, the third right support portion 31a and the third left support portion 31b. In this case, the respective support portions 17a, 17b, 21a, 21b, 31a and 31b are supported and fixed to have the respective surfaces in the same plane.

Besides the fixed portion 50, a fixed portion that faces the back surface 2b of the first movable portion 2 and the back surface 4b of the second movable portion 4 may be provided to fix and support the respective back surfaces of support portions 17a, 17b, 21a, 21b, 31a and 31b using a support member which integrally extends from the fixed portion.

The fixed portion 50 has a moving space formed therein which allows the first movable portion 2 and the second movable portion 4 to move up and down while fixing the support portions 17a, 17b, 21a, 21b, 31a and 31b so as not to move.

Referring to Fig. 3, first fixed electrodes 51, 51 and a second fixed electrode 52 are provided on the lower surface of the fixed portion 50. The fixed portion 50 is formed of the silicon substrate, and the respective fixed electrodes 51, 51, and 52 are formed on the lower surface 50a of the fixed portion 50 by sputtering or plating the conductive metal material via an insulating layer. A first movable electrode which faces the first fixed electrodes 51, 51 is formed on the upper surface 2a of the first movable portion 2 via the insulating layer in the sputtering or plating process. A second movable electrode which faces the second fixed electrode 52 is formed on the upper surface 4a of the second movable portion 4 via the insulating layer in the sputtering or the plating process.

In the aforementioned structure, the first movable electrode provided on the first movable portion 2 and the second movable electrode provided on the second movable portion 4 function as independent electrodes which are not electrically conducted with each other. Meanwhile, the first fixed electrodes 51, 51 and the second fixed electrode 52 provided on the fixed portion 50 may be structured as independent electrodes. Alternatively, the first fixed electrodes 51, 51 may be integrally formed with the second fixed electrode 52, or they may be in the form of common fixed electrodes which are electrically conducted with one another.

In the case where the first movable portion 2 and the second movable portion 4 are formed of the conductive material such as the silicon substrate, the first movable portion 2 by itself may be used as the first movable electrode, and the second movable portion 4 by itself may be used as the second movable portion. In such a case, the same substrate is used for producing the first movable portion 2 and the second movable portion 4, and accordingly, the first and the second movable electrodes become the common movable electrodes which are electrically conducted with each other. In this case, the first fixed electrodes 51, 51, and the second fixed electrode 52 are structured as independent electrodes so as not to be electrically conducted. This makes it possible to obtain each change in the electrostatic capacity between the first movable portion 2 and the first fixed electrodes 51, 51, and the electrostatic capacity between the second movable portion 4 and the second fixed electrode 52, individually.

The movable sensor 1 keeps the state where surfaces of all the parts are in the same plane under the elastic restoring force of the torsion bars respectively provided in the fulcrum connection portions and the connection portions as shown in Fig. 1 when the external force (acceleration) is not exerted.

When the acceleration is externally exerted to the movable sensor 1, the acceleration acts on the support portions 17a, 17b, 21a, 21b, 31a and 31b, and support members for supporting those portions. As mass of the first movable portion 2 is larger than that of the second movable portion 4, the first movable portion 2 tends to reside in the absolute space with inertial force. As a result, the first movable portion moves relative to the support portions 17a, 17b, 21a, 21b, 31a and 31b in the direction opposite the acting direction of the acceleration.

Figs. 2 and 3 show the operation states when the downward acceleration acts on the fixed portion 50, and support portions 17a, 17b, 21a, 21b, 31a and 31b. As the first movable portion 2 tries to reside with the inertial force, and moves upward relative to the fixed portion 50. The right connection link portion 10a rotates around the fulcrum connection portion 16a, and further the left connection link portion 10b rotates around the fulcrum connection portion 16b. As a result, the second movable portion 4 moves downward relative to the fixed portion 50. The first movable portion 2 and the second movable portion 4 are supported with the right connection link portion 10a and the left connection link portion 10b at both sides, and the right connection link portion 10a is point symmetrical with respect to the left connection link portion 10b. So the first movable portion 2 and the second movable portion 4 move in opposite directions while keeping parallel attitudes.

First movable portion 2 and the second movable portion 4 are connected with the right connection link portion 10a and the left connection link portion 10b so as to move in opposite directions while keeping the parallel attitudes. The right outer support link portion 20a, the left outer support link portion 20b, the right inner support link portion 30a and the left inner support link portion 30b allow the first movable portion 2 and the second movable portion 4 to move while keeping the parallel attitudes in stable state.

Referring to Fig. 3, when the first movable portion 2 moves up, the distance between the first fixed electrode 51 and the first movable electrode provided on the upper surface 2a of the first movable portion 2 is reduced in the fixed portion 50, and the electrostatic capacity between the electrodes is increased. Meanwhile, as the second movable portion 4 moves down, the distance between the second fixed electrode 52 and the second movable electrode provided on the upper surface of the second movable portion 4 is increased, thus reducing the electrostatic capacity between the electrodes. The difference between change in the electrostatic capacity derived from the first fixed electrode 51 and change in the electrostatic capacity derived from the second fixed electrode 52 is obtained to improve the detection output. The difference of the change in the electrostatic capacity also allows cancelation of fluctuation of the output and noise owing to the temperature property.

As the displacement of the first movable portion 2 is proportional to the acceleration, it is possible to detect the acceleration by obtaining the detection output of the change in the electrostatic capacity.

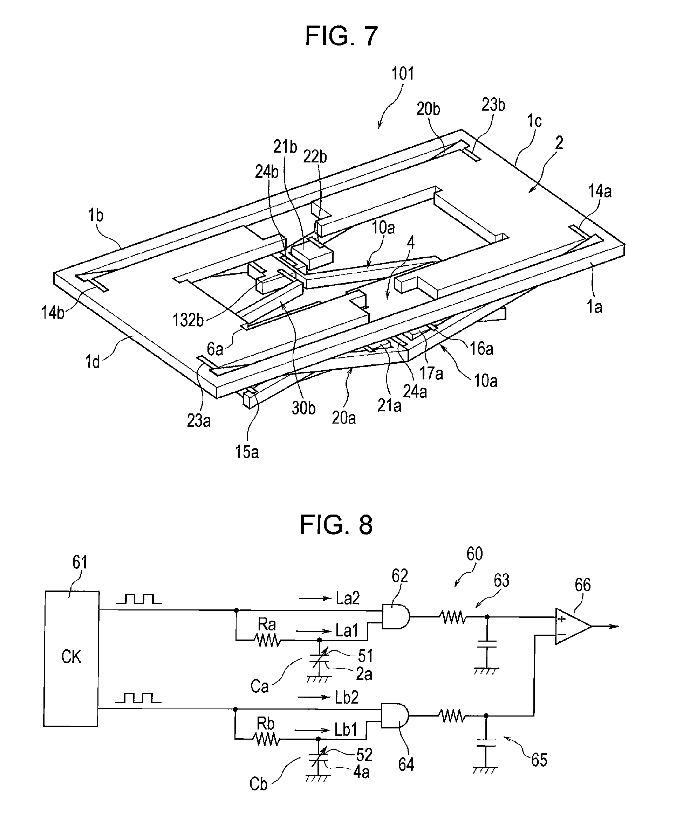

Fig. 8 illustrates an example of a detection circuit 60 for obtaining the difference of the change in the electrostatic capacity.

The detection circuit 60 illustrated in Fig. 8 includes a variable capacitor Ca formed of the first fixed electrode 51 and the first movable electrode provided on the upper surface 2a of the first movable portion 2, and a variable capacitor Cb formed of the second fixed electrode 52 and the second movable electrode provided on the upper surface 4a of the second movable portion 4.

A pulse generator 61 generates a pulse signal which changes the voltage by a rectangular wave at a constant frequency. The pulse signal is supplied to a delay path La1 formed of a resistor Ra and the variable capacitor Ca. The voltage having its rise-up delayed on the delay path La1 and the voltage of the pulse signal which has passed a bypass path La2 without passing the delay path La1 are applied to an AND circuit 62. On the delay path La1, the time at which the voltage rises up owing to the change in the electrostatic capacity of the variable capacitor Ca is changed. The AND circuit 62 outputs the voltage at the pulse width corresponding to the change in the rise-up time of the voltage. The rectangular wave output from the AND circuit 62 is smoothed by a smoothing circuit 63.

The voltage applied through a delay path Lb1 formed of a resistor Rb and a variable capacitor Cb, and the pulse signal which has passed the bypass path Lb2 are applied to an AND circuit 64. The AND circuit 64 outputs voltage with the pulse with corresponding to the change in the electrostatic capacity of the variable capacitor Cb. The output voltage is smoothed by a smoothing circuit 65.

Fluctuation of the pulse width of the voltage applied to the smoothing circuit 63 from the AND circuit 62 is inversely related to fluctuation of the pulse width of the voltage applied to the smoothing circuit 65 from the AND circuit 64. The difference between those outputs is obtained by a differential circuit 66 for providing the detection output to which the absolute value is added. This makes it possible to cancel the fluctuation and noise owing to the temperature change.

Preferably in the aforementioned circuit, capacity of the variable capacitor Ca is equal to that of the variable capacitor Cb so as to cancel the fluctuation and noise owing to the temperature change. Each area of the first fixed electrodes 51, 51 and the second fixed electrode 52 is set so that the capacity of the variable capacitor Ca is equal to that of the variable capacitor Cb in opposed relation to the movable electrodes.

Figs. 6 and 7 are perspective views each showing a movable sensor 101 according to a second embodiment of the present invention. Fig. 6 shows the state where no external force is exerted, and Fig. 7 shows the state where the first and the second movable portions are moving in opposite directions.

Members of the movable sensor 101 shown in Figs. 6 and 7, which function in the same way as those of the movable sensor 1 according to the first embodiment will be designated with the same signs, and explanations thereof, thus will be omitted.

The third right support portion 31a and the third left support portion 31b of the movable sensor 1 shown in Figs. 1 and 2 are omitted from the movable sensor 101 shown in Figs. 6 and 7. The movable sensor 101 includes four support portions, that is, the first right support portion 17a, the first left support portion 17b, the second right support portion 21a and the second left support portion 21b, which are fixed to the fixed portion 50 so as to be used.

The first right support portion 17a is provided with the fulcrum connection portion 16a for rotatably supporting the right connection link portion 10a, and the first left support portion 17b is provided with the fulcrum connection portion 16b for rotatably supporting the left connection link portion 10b. The second right support portion 21a is provided with the fulcrum connection portion 22a for supporting the right outer support link portion 20a, and the second left support portion 21b is provided with the fulcrum connection portion 22b for supporting the left outer support link portion 20b.

In the movable sensor 101, the first right support portion 17a is provided with a fulcrum connection portion 132a for supporting the right inner support link portion 30a. The first left support portion 17b is provided with a fulcrum connection portion 132b for supporting the left inner support link portion 30b.

The operation of the movable sensor 101 is the same as that of the movable sensor 1. The number of the support portions may be reduced to four, thus simplifying the support structure.

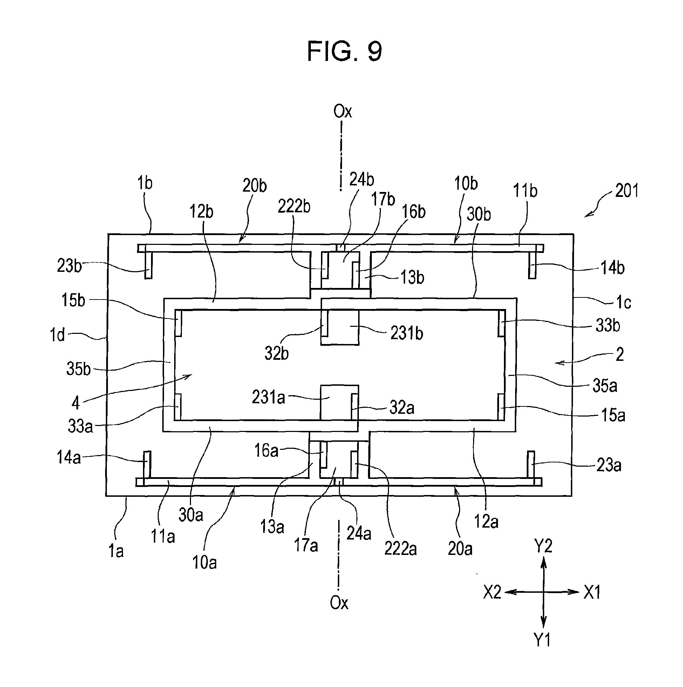

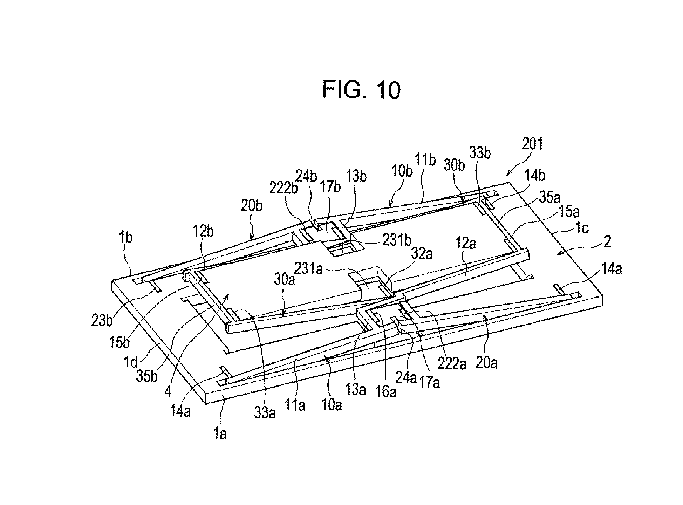

Figs. 9 and 10 illustrate a movable sensor 201 according to a third embodiment of the present invention. Fig. 9 is a plan view showing the state where the external force is not exerted. Fig. 10 is a perspective view showing a momentary state where the first movable portion and the second movable portion are moving in opposite directions. Referring to Fig. 10, unlike Figs. 2 and 7, the first movable portion 2 moves down relative to the fixed portion 50, and as a result, the second movable portion 4 moves up. The drawing illustrates the momentary state where the first movable portion 2 moves away from the first fixed electrodes 51, 51, and the second movable portion 4 moves close to the second fixed electrode 52.

Members of the movable sensor 201 shown in Figs. 9 and 10, which function in the same way as those of the movable sensor 1 according to the first embodiment and the movable sensor 101 according to the second embodiment will be designated with the same signs, and explanations thereof, thus will be omitted.

The movable sensor 201 shown in Figs. 9 and 10 has the first right support portion 17a and the first left support portion 17b apart from each other in the left-to-right direction (Y1-Y2 direction), and at the inner sides thereof, a second right support portion 231a and a second left support portion 231b are provided apart from each other in the left-to-right direction. The first right support portion 17a rotatably supports the right connect link portion 10a and the right outer support link portion 20a, and the first left support portion 17b rotatably supports the left connection link portion 10b and the left outer support link portion 20b. The second right support portion 231a rotatably supports the left inner support link portion 30a, and the second left support portion 231b rotatably supports the left inner support link portion 30b.

Referring to Fig. 9, assuming that the line which extends in the left-to-right direction (Y1-Y2 direction) to pass through the center between the short sides 1c and 1d of the movable sensor 201 is set to a lateral center line Ox, the center which separates the first right support portion 17a and the first left support portion 17b in the front-to-rear direction is positioned on the lateral center line Ox, and the center which separates the second right support portion 231a and the second left support portion 231b in the front-to-rear direction is positioned on the lateral center line Ox. Each width dimension of the first right support portion 17a and the first left support portion 17b in the front-to-right direction (X1-X2 direction) is the same as the one of the second right support portion 231a and the second left support portion 231b in the front-to-rear direction (X1-X2 direction).

The first connection arm 11a of the right connection link portion 10a extends rearward (X direction), and its end portion and the first movable portion 2 are rotatably connected with the connection portion 14a. The connection portion 14a is provided with the torsion bar 19a as shown in Fig. 4. The other connection portions and the fulcrum connection portions to be described later are also provided with the torsion bars. The second connection arm 12a provided for the right connection link portion 10a extends forward (X1 direction), and its end portion and the second movable portion 4 are rotatably connected with the connection portion 15a. The intermediate connection portion 13a of the right connection link portion 10a and the first right support portion 17a are rotatably supported via the fulcrum connection portion 16a.

Similarly, the left connection link portion 10b has the end portion of the first connection arm 11b extending forward (X1 direction) and the first movable portion 2 rotatably connected with the connection portion 14b, and further the end portion of the second connection arm 12b extending rearward (X2 direction) and the second movable portion 4 rotatably connected with the connection portion 15b. The intermediate connection portion 13b and the first left support portion 17b are rotatably supported with the fulcrum connection portion 16b.

The right outer support link portion 20a has the proximal portion rotatably supported at the first right support portion 17a with a fulcrum connection portion 222a, and its front end portion (X1 direction) and the first movable portion 2 are rotatably connected with the connection portion 23a. The left outer support link portion 20b has its proximal portion rotatably supported at the first left support portion 17b with a fulcrum connection portion 222b, and its rear end portion (X2 direction) and the first movable portion 2 are rotatably connected with the connection portion 23b.

The right connection link portion 10a and the right outer support link portion 20a are connected via the deformable inter-link connection portion 24a. The left connection link portion 10b and the left outer support link portion 20b are also rotatably connected via the deformable inter-link connection portion 24b.

The second right support portion 231a is rotatably connected to the right inner support link portion 30a via the fulcrum connection portion 32a, and a rear end portion (X2 direction) of the right inner support link portion 30a and the second movable portion 4 are rotatably connected with the connection portion 33a. The second left support portion 231b is rotatably connected to the left inner support link portion 30b via the fulcrum connection portion 32b, and the front end portion (X1 direction) of the left inner support link portion 30b and the second movable portion 4 are rotatably connected with the connection portion 33b.

The second connection arm 12a of the right connection link portion 10a and the left inner support link portion 30b are integrally connected with a beam portion 35a which extends in the left-to-right direction, and the second connection arm 12b of the left connection link portion 10b and the right inner support link portion 30b are integrally connected with a beam 35b which extends in the left-to-right direction.

The movable sensor 201 shown in Figs. 9 and 10 is structured so that the fulcrum connection portions 16a and 222a, and 16b and 222b hardly move up and down from their original positions when warrpage occurs in the fixed portion 50 to which the first right support portion 17a and the first left support portion 17b are fixed, that is, the fixed substrate toward the front-to-rear direction (X1-X2 direction).

With reference to the movable sensor 101 shown in Fig. 6 as a comparable example, in the movable sensor 101, the fulcrum connection portion 16a for supporting the right connection link portion 10a and the fulcrum connection portion 22a for supporting the right outer support link portion 20a are provided at the first right support portion 17a and the second right support portion 21a, which are apart from each other in the front-to-rear direction. When warrpage occurs in the fixed portion 50 toward the front-to-rear direction (X1-X2), the first right support portion 17a may tilt to have the X1 side directed downward, and the second right support portion 21a may tilt to have the X2 side directed downward. At this time, the fulcrum connection portions 16a and 22a move down below their original positions even in the neutral state where no acceleration is applied. As a result, the first movable portion 2 moves down from the original neutral attitude, and the second movable portion 4 moves up from the original neutral attitude. The detection output proportional to each displacement of the respective movable portions 2, 4 is generated from the detection circuit 60 shown in Fig. 8 as offset noise even if no acceleration is applied.

Meanwhile, in the movable sensor 201 shown in Figs. 9 and 10, the fulcrum connection portions 16a and 222a are provided at the first right support portion 17a, and the fulcrum connection portions 16b and 222b are provided at the first left support portion 17b. The first right support portion 17a and the first left support portion 17b are positioned on the lateral center line Ox. When warrpage occurs in the fixed portion 50, the fulcrum connection portions 16a, 222a, and 16b, 222b may be prevented from largely moving in the up-to-down direction from their original positions. This makes it possible to reduce the offset noise in the neutral state as described above.

In the movable sensor 1 shown in Fig. 1, the fulcrum connection portion 32a for supporting the right inner support link portion 30a and the fulcrum connection portion 32b for supporting the left inner support link portion 30b are positioned apart from each other in the front-to-rear direction. When warrpage occurs in the fixed portion 50 in the front-to-rear direction, the fulcrum connection portions 32a and 32b move up or down from their original neutral positions even if no acceleration is applied. As a result, the second movable portion 4 moves up or down from the original position.

In the movable sensor 201 shown in Figs. 9 and 10, the fulcrum connection portion 32a for supporting the right inner support link portion 30a and the fulcrum connection portion 32b for supporting the left inner support link portion 30b are not so far from the lateral center line Ox in the front-to-rear direction. When warrpage occurs in the fixed portion 50, the fulcrum connection portions 32a and 32b hardly move in the up-to-down direction, thus suppressing the second movable portion 4 from moving up or down from the original neutral attitude. This makes it possible to reduce the offset noise.

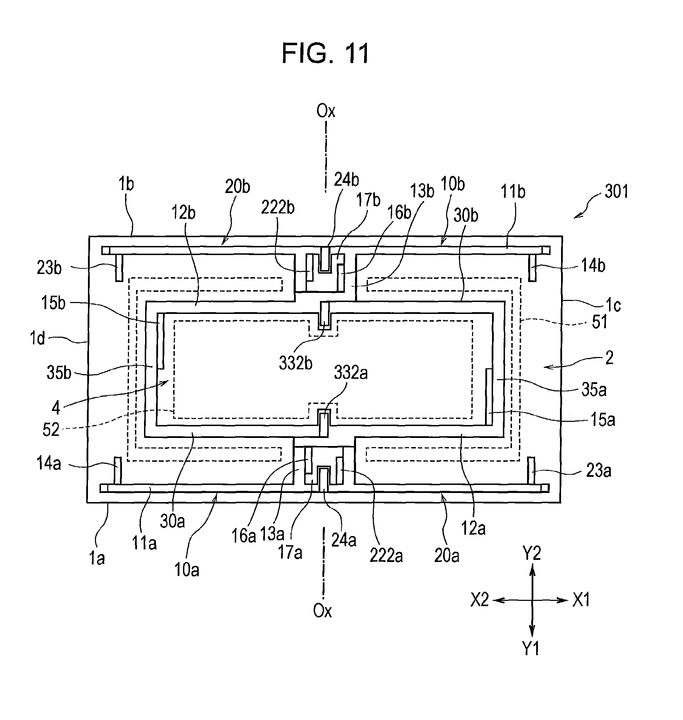

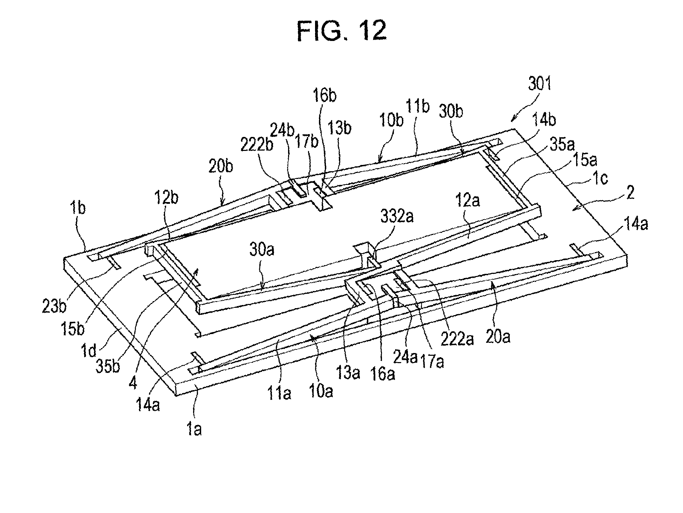

Figs. 11 and 12 are perspective views each showing a movable sensor 301 according to a fourth embodiment. Fig. 11 shows the state where the external force is not exerted, and Fig. 12 shows the state where the first movable portion 2 and the second movable portion 4 are moving in opposite directions.

The movable sensor 301 shown in Figs. 11 and 12 is formed by improving the movable sensor 201 according to the third embodiment shown in Figs. 9 and 10. The movable sensor 301 will be described mainly with respect to the part different from that of the movable sensor 201. Members of the movable sensor 301 shown in Figs. 11 and 12, which function in the same way as those of the movable sensor 201 will be designated with the same signs, and explanations thereof, thus will be omitted.

The second right support portion 231a and the second left support portion 231b of the movable sensor 201 shown in Figs. 9 and 10 are omitted from the movable sensor 301 shown in Figs. 11 and 12. The first right support portion 17a and the first left support portion 17b are only fixed to the fixed portion 50.

The right connection link portion 10a is rotatably supported at the first right support portion 17a via the fulcrum connection portion 16a, and the right outer support link portion 20a is rotatably supported at the first right support portion 17a via the fulcrum connection portion 222a. The right connection link portion 10a and the right outer support link portion 20a are rotatably connected with the inter-link connection portion 24a. Likewise, the left connection link portion 10b is rotatably supported at the first left support portion 17b via the fulcrum connection portion 16b. The left outer support link portion 20b is rotatably supported at the first left support portion 17b via the fulcrum connection portion 222b. The left connection link portion 10b and the left outer support link portion 20b are rotatably connected via the inter-link connection portion 24b.

The right inner support link portion 30a connected to the second movable portion 4 is rotatably connected to the right connection link portion 10a via an inner inter-link connection portion 332a, and in the same way, the left inner support link portion 30b connected to the second movable portion 4 is rotatably connected to the left connection link portion 10b via an inner inter-link connection portion 332b.

The inter-link connection portion 24a and the inner inter-link connection portion 332a at the right side and the inter-link connection portion 24b and the inner inter-link connection portion 332b at the left side are all aligned on the lateral center line Ox. The lateral center line Ox is positioned at the center between the connection portions 23a, 14b at the front (X1 side) and the connection portions 23b, 14a at the rear (X2 side) of the link portion and the first movable portion 2.

When the right connection link portion 10a and the left connection link portion 10b rotate with respect to the fulcrum connection portions 16a and 16b each as the fulcrum, the right inner support link portion 30a rotates with respect to the inner inter-link connection portion 332a as the fulcrum, and the left inner side support link portion 30b rotates with respect to the inner inter-link connection portion 332b as the fulcrum. The second movable portion 4 operates in the opposite direction of the first mobile part 2 while holding the attitude parallel thereto.

In the movable sensor 301 shown in Figs. 11 and 12, the first right support portion 17a and the first left support portion 17b are only fixed to the fixed portion 50. When warrpage occurs in the fixed portion 50 owing to the thermal stress, displacement of the fulcrum portion of each of the respective link portions may be suppressed, thus easily reducing the offset noise.

The movable sensor 1 shown in Figs. 1 and 2, the movable sensor 101 shown in Figs. 6 and 7, the movable sensor 201 shown in Figs. 9 and 10, and the movable sensor 301 shown in Figs. 11 and 12 are cut from the rectangular silicon substrate, respectively, and may have compact and thin structures. Each of those sensors has no member which protrudes from the upper and back surfaces, thus easily positioning the support structure and the fixed portion 50 for supporting the fixed electrodes 51, 52.

In Fig. 11, the first fixed electrode 51 opposite the first movable portion 2 and the second fixed electrode 52 opposite the second movable portion are indicated by dashed lines.

The first fixed electrode 51 generally faces the first movable portion 2, and has an edge portion disposed at the inner side of the edge portion of the first movable portion 2 apart therefrom. The second fixed electrode 52 generally faces the second movable portion 4, and has an edge portion disposed at the inner side of the edge of the second movable portion 4 apart therefrom. As a result, accurate detection of the change in the electrostatic capacity may be constantly conducted without reducing the area defined by the oppositely provided first movable portion 2 and the first fixed electrode 51, and the area defined by the oppositely provided second movable portion 4 and the second fixed electrode 52 even if the first movable portion 2 generally functioning as the first movable electrode and the second movable portion 4 generally functioning as the second movable electrode move in either X or Y direction owing to oscillation.

Areas of the first fixed electrodes 51, 51 and the second fixed electrode 52 are set so that capacity of the variable capacitor Ca becomes equal to that of the variable capacitor Cb as shown in Fig. 8.

### Reference Signs List

1, 101, 201 movable sensor
2 first movable portion
4 second movable portion
10a right connection link portion
10b left connection link portion
14a, 14b, 15a, 15b connection portion
16a, 16b fulcrum connection portion
17a first right support portion
17b first left support portion
20a right outer support link portion
20b left outer support link portion
21a second right support portion
21b second left support portion
22a, 22b fulcrum connection portion
23a, 23b connection portion
24a, 24b inter-link connection portion
30a right inner support link portion
30b left inner support link portion
31a third right support portion
31b third left support portion
32a, 32b fulcrum connection portion
33a, 33b connection portion
50 fixed portion
51 first fixed electrode
52 second fixed electrode
132a, 132b fulcrum connection portion
222a, 222b fulcrum connection portion
231a second right support portion
231b second left support portion
332a, 232b inner inter-link connection portion

## Claims

1. A movable sensor which has electrodes oppositely provided on a movable portion and a fixed portion for detecting a change in an electrostatic capacity between the electrodes when the movable portion moves close to or away from the fixed portion, wherein:
a first movable portion, a second movable portion, and link portions which are rotatably connected to both of the movable portions are provided, the link portion is operable so that one of the first movable portion and the second movable portion moves close to the fixed portion and the other moves away from the fixed portion when the link portion rotates with respect to a fulcrum which is set between a connection portion connected to the first movable portion and a connection portion connected to the second movable portion; and
a first movable electrode is provided on the first movable portion, and a second movable electrode is provided on the second movable portion on a surface in a same direction as each of the movable portions, and the fixed portion includes a first fixed electrode opposite the first movable electrode, and a second fixed electrode opposite the second movable electrode.

2. The movable sensor according to Claim 1, further comprising a detection circuit which detects a difference between the change in the electrostatic capacity between the first movable electrode and the first fixed electrode, and the change in the electrostatic capacity between the second movable electrode and the second fixed electrode.

3. The movable sensor according to Claim 1 or 2, wherein one of the first movable portion and the second movable portion has mass larger than that of the other, and the movable portion in larger mass moves in response to an externally applied acceleration, and the movable portion in smaller mass moves in an opposite direction of the movable portion in larger mass.

4. The movable sensor according to any one of Claims 1 to 3, wherein the first movable portion has a same thickness as that of the second movable portion, and when each upper surface and a back surface of the first and the second movable portions is in the same plane, the link portion and a support portion for rotatably supporting the link portion are located in a thickness range defined by the upper surface and the back surface.

5. The movable sensor according to Claim 4, wherein the first movable portion, the second movable portion, the link portion and the support portion are cut from a same plate material.

6. The movable sensor according to Claim 5, wherein a connection portion between the first movable portion and the link portion, a connection portion between the second movable portion and the link portion, and a connection portion between the link portion and the support portion at the fulcrum have respective members rotatably connected via torsion bars, each of which is formed of a part of the plate material.

7. The movable sensor according to any one of Claims 1 to 6, wherein an electrically conductive material is used for forming the first movable portion and the second movable portion, the first movable portion generally functions as the first movable electrode, and the second movable portion generally functions as the second movable electrode.

8. The movable sensor according to any one of Claims 1 to 7, wherein:
the link portion includes a right connection link portion and a left connection link portion extending in a front-to-rear (X) direction which are apart from each other in a left-to-right (Y) direction, the right connection link portion is rotatably supported with a first right support portion via a right fulcrum, and the left connection link portion is rotatably supported with the first left support portion via a left fulcrum;
any one of a connection portion between the right connection link portion and the first movable portion and a connection portion between the left connection link portion and the first movable portion is located at a front position (X1), and the other is located at a rear position (X2);
a connection portion between the right connection link portion and the second movable portion is located opposite a connection portion between the right connection link portion and the first movable portion in the front-to-rear direction with respect to the right fulcrum, and a connection portion between the left connection link portion and the second movable portion is located opposite a connection portion between the left connection link portion and the first movable portion in the front-to-rear direction with respect to the left fulcrum; and
the first right support portion and the first left support portion are fixed to the fixed portion.

9. The movable sensor according to Claim 8, wherein:
the right outer support link portion is rotatably connected to the first right support portion and the first movable portion, and a connection portion between the right outer support link portion and the first movable portion is located opposite a connection portion between the right connection link portion and the first movable portion in the front-to-rear direction; and
the left outer support link portion is rotatably connected to the first left support portion and the first movable portion, and a connection portion between the left outer support link portion and the first movable portion is located opposite a connection portion between the left connection link portion and the first movable portion in the front-to-rear direction.

10. The movable sensor according to Claim 8 or 9, further comprising a second right support portion and a second left support portion, wherein:
a right inner support link portion is rotatably connected to the second right support portion and the second movable portion, and a connection portion between the right inner support link portion and the second movable portion is located opposite a connection portion between the right connection link portion and the second movable portion in the front-to-rear direction; and
the left inner support link portion is rotatably connected to the second left support portion and the second movable portion, and a connection portion between the left inner support link portion and the second movable portion is located opposite a connection portion between the left connection link portion and the second movable portion in the front-to-rear direction.

11. The movable sensor according to Claim 8 or 9, wherein the first right support portion and the first left support portion are aligned on the same line which extends in the left-to-right (Y) direction.

12. The movable sensor according to Claim 10, wherein the first right support portion and the first left support portion, and the second right support portion and the second left support portion are aligned on the same line which extends in the left-to-right (Y) direction.

13. The movable sensor according to Claim 8, wherein:
a right outer support link portion is rotatably connected to the right connection link portion via an inter-link connection portion, and a left outer support link portion is rotatably connected to the left connection link portion via an inter-link connection portion;
a connection portion between the right outer support link portion and the first movable portion is located opposite a connection portion between the right connection link portion and the first movable portion in the front-to-rear direction with respect to the inter-link connection portion;
a connection portion between the left outer support link portion and the first movable portion is located opposite a connection portion between the left connection link portion and the first movable portion in the front-to-rear direction with respect to the inter-link connection portion; and
a connection portion between the right outer support link portion and the first movable portion is located opposite a connection portion between the left outer support link portion and the first movable portion in the front-to-rear direction.

14. The movable sensor according to Claim 13, wherein:
a right inner support link portion is rotatably connected to the right connection link portion via an inner inter-link connection portion, and a left inner support link portion is rotatably connected to the left connection link portion via an inner inter-link connection portion;
a connection portion between the right inner support link portion and the second movable portion is located opposite a connection portion between the right connection link portion and the second movable portion in the front-to-rear direction with respect to the inner inter-link connection portion;
a connection portion between the left inner support link portion and the second movable portion is located opposite a connection portion between the left connection link portion and the second movable portion in the front-to-rear direction with respect to the inner inter-link connection portion; and
a connection portion between the right inner support link portion and the second movable portion is located opposite a connection portion between the left inner support link portion and the second movable portion in the front-to-rear direction.

15. The movable sensor according to Claim 13 or 14, wherein the inter-link connection portion and the inner inter-link connection portion are aligned on the same line which extends in the left-to-right (Y) direction.
